# EUROPEAN PATENT SPECIFICATION

(11) **EP 1 918 422 B1**
(45) Date of publication and mention of the grant of the patent: **12.03.2014**
(21) Application number: 07117460.1
(22) Date of filing: 28.09.2007
(51) Int. Cl.: C23C 30/00

(54) **Coated cutting tool**
Beschichtetes Schneidwerkzeug
Outil de coupe revêtu

(30) Priority: 18.10.2006 SE 0602193
(43) Date of publication of application: 07.05.2008
(73) Proprietor: Sandvik Intellectual Property AB, 811 81 Sandviken (SE)
(72) Inventor: Reineck, Ingrid, SE 141 72, Segeltorp (SE); Collin, Marianne, SE 125 54, Älvsjö (SE); Huy Trihn, David, SE 584 34, Linköping (SE); Högberg, Hans, SE 582 32, Linköping (SE); Hultman, Lars, SE 589 31, Linköping (SE)
(74) Representative: Hägglöf, Henrik

(56) References cited:
- EP-A- 1 717 347
- WO-A-99/58738
- WO-A-2004/029321
- US-A- 4 701 384
- KUNTZ J D ET AL: "NANOCRYSTALLINE MATRIX CERAMIC COMPOSITES FOR IMPROVED FRACTURE TOUGHNESS" MRS BULLETIN, PITTSBURGH, US, 1 January 2004 (2004-01-01), pages 22-27, XP008078761

## Description

The present invention relates to a coated cutting tool for metal machining having a substrate of a hard alloy and, on the surface of said substrate, a hard and wear resistant refractory coating is deposited by Physical Vapour Deposition (PVD) or Plasma Enhanced Chemical Vapour Deposition (PECVD).

The process of depositing thin ceramic coatings (1-20 µm) of materials like alumina, titanium carbides and/or nitrides onto e.g. a cemented carbide cutting tool is a well established technology and the tool life of the coated cutting tool, when used in metal machining, is considerably prolonged. The prolonged service life of the tool may under certain conditions extend up to several hundred percent greater than that of an uncoated cutting tool. These ceramic coatings generally comprise either a single layer or a combination of layers. Modern commercial cutting tools are characterized by a plurality of layer combinations with double or multilayer structures. The total coating thickness varies between 1 and 20 µm and the thickness of the individual sub-layers varies between a few micrometers down to some hundredths of a micrometer.

The established technologies for depositing such layers are CVD and PVD (see e.g. U.S. 4,619,866 and U.S. 4,346,123). PVD coated commercial cutting tools of cemented carbides or high speed steels usually have a single layer of TiN, Ti(C,N) or (Ti,Al)N, homogeneous in composition, or multilayer coatings of said phases, each layer being a single phase material.

There exist several PVD techniques capable of producing thin, refractory coatings on cutting tools. The most established methods are ion plating, magnetron sputtering, arc discharge evaporation and IBAD (Ion Beam Assisted Deposition) as well as hybrid processes of the mentioned methods. Each method has its own merits and the intrinsic properties of the produced layers such as microstructure and grain size, hardness, state of stress, cohesion and adhesion to the underlying substrate may vary depending on the particular PVD method chosen. An improvement in the wear resistance or the edge integrity of a PVD coated cutting tool being used in a specific machining operation can thus be accomplished by optimizing one or several of the above mentioned properties.

Particle strengthened ceramics are well known as construction materials in the bulk form, however not as nano-composites until recently. Alumina bulk ceramics with different nano-dispersed particles are disclosed in J. F. Kuntz et al, MRS Bulletin Jan 2004, pp 22 - 27. Zirconia and titania toughened alumina CVD layers are disclosed in for example U.S. 6,660,371 and US 4,701,384. In these latter disclosures, the layers are deposited by CVD technique and hence the ZrO₂ phase formed is the thermodynamically stable phase, namely the monoclinic phase. Furthermore, the CVD deposited layers are in general under tensile stress or low level compressive stress, whereas PVD or PECVD layers are typically under high level compressive stress due to the inherent nature of these deposition processes. In US 2005/0260432 blasting of alumina+zirconia CVD layers is described to give a compressive stress level. Blasting processes are known to introduce compressive stresses at moderate levels.

Metastable phases of zirconia, such as the tetragonal or cubic phases, have been shown to further enhance bulk ceramics through a mechanism known as transformation toughening (Hannink et al, J. Am. Ceram. Soc 83 (3) 461 - 87; Evans, Am. Ceram. Soc. 73 (2) 187-206 (1990)). Such metastable phases have been shown to be promoted by adding stabilizing elements such as Y or Ce or by the presence of an oxygen deficient environment, such as vacuum (Tomaszewski et al, J. Mater. Sci. Lett 7 (1988) 778-80), which is typically required for PVD applications. Variation of PVD process parameters has been shown to cause variations in the oxygen stoichiometry and the formation of metastable phases in zirconia, particularly the cubic zirconia phase (Ben Amor et al, Mater. Sci. Eng. B57 (1998) 28).

Multilayered PVD layers consisting of metal nitrides or carbides for cutting applications are described in EP 0709483 where a symmetric multilayer structure of metal nitrides and carbides is revealed and US 6,103,357 which describes an aperiodic laminated multilayer of metal nitrides and carbides.

Swedish Patent Application No. SE 0500867-7 and SE 0600104-4 disclose a cutting tool insert for metal machining on which at least on the functioning parts of the surface thereof a thin, adherent, hard and wear resistant coating is applied. The coating comprises a metal oxide+metal oxide nano-composite layer consisting of two components with a grain size of 1 - 100 nm.

It is an object of the present invention to provide a PVD or PECVD coated cutting tool wherein the coating has improved wear resistance in combination improved adhesion properties.

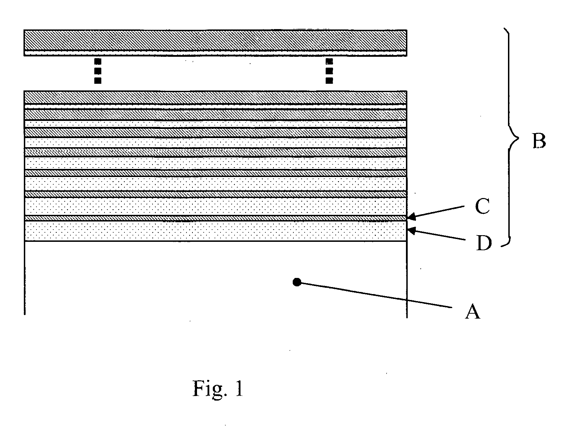

Fig. 1 is a schematic representation of a cross section taken through a coated cutting tool of the present invention showing a showing a substrate, A, coated with a laminated multilayer, B, comprising alternating metal oxide+metal oxide nano-composite layers of type C and metal oxide+metal oxide nano-composite layers of type D.

According to the present invention there is provided a cutting tool for metal machining such as turning, milling and drilling comprising a substrate of a hard alloy of cemented carbide, cermet, ceramics, cubic boron nitride or high speed steel, preferably cemented carbide or cermet, onto which a wear resistant coating comprising a laminated multilayer has been deposited. The shape of the cutting tool includes indexable inserts as well as shank type tools such as drills, end mills etc. The coating may in addition comprise, beneath the laminated multilayer, at least one first, inner single layer or multilayer of metal carbides, nitrides or carbonitrides where the metal atoms are one or more of Ti, Nb, V, Mo, Zr, Cr, Al, Hf, Ta, Y or Si with a thickness in the range 0.2 to 20 µm according to prior art. The coating is applied onto the entire substrate or at least on the functioning surfaces thereof, e.g. the cutting edge, rake face, flank face and any other surfaces which participate in the metal cutting process.

The coating according to the invention is adherently bonded to the substrate and comprises a laminated multilayer of alternating PVD or PECVD metal oxide layers, Me₁X+Me₂X+Me₁X+Me₂X..., where the metal atoms Me₁ and Me₂ are one or more of Ti, Nb, V, Mo, Zr, Cr, Al, Hf, Ta, Y and Si, preferably Hf, Ta, Zr and Al, most preferably Zr and Al, and where at least one of Me₁X and Me₂X is a nano-composite layer of a dispersed metal oxide component in a metal oxide matrix, hereinafter referred to as a metal oxide+metal oxide nano-composite, and wherein the laminated multilayer has a compositional gradient with regard to the concentration of one or more of the metal atom(s) in the direction from the outer surface of the coating towards the substrate, the gradient being such that the difference between the average concentration of the outermost portion of the multilayer and the average concentration of the innermost portion of the multilayer is at least 5 at-% in absolute units. The layers Me₁X and Me₂X are different in composition or structure or both. The sequence of the individual Me₁X or Me₂X layer thicknesses is preferably aperiodic throughout the entire multilayer. By aperiodic is understood that the thickness of a particular individual layer in the laminated multilayer does not depend on the thickness of an individual layer immediately beneath nor does it bear any relation to an individual layer above the particular individual layer. Hence, the laminated multilayer does not have any repeat period in the sequence of individual coating thicknesses. Furthermore, the individual layer thickness is larger than 0.4 nm but smaller than 50 nm, preferably larger than 1 nm and smaller than 30 nm, most preferably larger than 5 nm and smaller than 20 nm. The laminated multilayer has a total thickness of between 0.2 and 20 µm, preferably 0.5 and 5 µm.

One individual metal oxide+metal oxide nano-composite layer is composed of at least two components with different composition and different structure. Each component is a single phase oxide of one metal element or a solid solution of two or more metal oxides. The microstructure of the material is characterized by nano-sized grains or columns of a component A with an average grain or column size of 1 - 100 nm, preferably 1 - 70 nm, most preferably 1 - 20 nm, surrounded by a component B. The mean linear intercept of component B is 0.5 - 200 nm, preferably 0.5 - 50 nm, most preferably 0.5 - 20 nm.

The metal oxide+metal oxide nano-composite layer may be understoichiometric in oxygen content with an oxygen:metal atomic ratio which is 85 - 99 %, preferably 90 - 97 %, of stoichiometric oxygen:metal atomic ratio.

The volume contents of components A and B are 40 - 95 % and 5 - 60 % respectively.

In one exemplary embodiment of the invention, the laminated multilayer is deposited directly onto a first, inner single layer or multilayer of metal carbides, nitrides or carbonitrides where the metal atoms are one or more of Ti, Nb, V, Mo, Zr, Cr, Al, Hf, Ta, Y and Si with a thickness in the range 0.2 to 20 µm, where one or more of the metal atom(s) of the at least one metal oxide+metal oxide nano-composite layer is a stronger carbide or nitride former than one or more of the metal atom(s) in the first, inner single layer or multilayer. Furthermore it is preferred, in the laminated multilayer, that the concentration of metal atom(s) being the stronger carbide or nitride former of the at least one metal oxide+metal oxide nano-composite layer is increased in the direction from the outer surface of the coating towards the substrate.

In one exemplary embodiment of the present invention, Me₁X is a metal oxide+metal oxide nano-composite layer containing grains or columns of component A and a surrounding component B, and Me₂X is a metal oxide+metal oxide nano-composite layer containing grains or columns of component A and a surrounding component B. Component A of Me₁X is the same as component A of Me₂X as is component B of Me₁X and Me₂X, but the metal atom(s) of component A is different from the metal atom(s) of component B. The volume content of component A in Me₁X is > the volume content of component A in Me₂X, preferably the volume content of components A in Me₁X is at least 2.5 % more than the volume content of components A in Me₂X in absolute units, most preferably the volume content of components A in Me₁X is at least 5 % more than the volume content of components A in Me₂X in absolute units. The laminated multilayer has a compositional gradient in the metal atom(s) of component A, as well as a compositional gradient in the metal atom(s) of component B, the direction of increasing metal atom(s) content in the laminated multilayer being opposite for component A and component B, due to a shift in the relation of the average Me₁X and/or Me₂X layer thicknesses throughout the multilayer.

In another exemplary embodiment of the present invention, Me₁X is a metal oxide+metal oxide nano-composite layer and Me₂X is a metal oxide+metal oxide nano-composite layer. The metal atom(s) of component A of Me₁X is different from the metal atom(s) of component A of Me₂X. Component B of Me₁X is the same as component B of Me₂X. The volume content of component A in Me₁X is equal to the volume content of component A in Me₂X. The laminated multilayer has a compositional gradient in the metal atom(s) of component A, due to a shift in the relation of the average Me₁X and/or Me₂X layer thicknesses throughout the multilayer. The average content of metal atom(s) of component A of Me₁X may e.g. be close to zero percent in the innermost part of the multilayer, i.e., the average Me₁X layer thickness is close to zero, hence the average content of metal atom(s) of component A of Me₂X is maximized. The average content of metal atom(s) of component A of Me₁X may increase to a maximum content towards the outermost part of the multilayer due to a gradually increased average Me₁X layer thickness towards the outermost part of the multilayer.

In another exemplary embodiment of the present invention, the first, inner single layer or multilayer comprises a Ti based carbide, nitride or carbonitride. Me₁X is a metal oxide+metal oxide nano-composite layer containing grains or columns of component A, preferably in the form of tetragonal or cubic zirconia, and a surrounding component B, preferably in the form of amorphous or crystalline alumina being one or both of alpha (α) and gamma (γ) phase, and Me₂X is a Al₂O₃ layer, preferably being one or both of alpha (α) and gamma (γ) phase. The laminated multilayer has a compositional gradient in the metal atom(s) of component A, due to a shift in the relation of the average Me₁X and/or Me₂X layer thicknesses throughout the multilayer.

In another embodiment, the first, inner single layer or multilayer comprises a Ti based carbide, nitride or carbonitride. Me₁X is a metal oxide+metal oxide nano-composite layer containing grains or columns of component A in the form of an oxide of hafnium and a surrounding component B in the form of amorphous or crystalline alumina being one or both of alpha (α) and gamma (γ) phase, and Me₂X is a Al₂O₃ layer, preferably being one or both of alpha (α) and gamma (γ) phase. The laminated multilayer has a compositional gradient in the metal atom(s) of component A, due to a shift in the relation of the average Me₁X and/or Me₂X layer thicknesses throughout the multilayer.

The coating may in addition comprise, on top of the laminated multilayer, at least one outer single layer or multilayer of metal carbides, nitrides or carbonitrides where the metal atoms are one or more of Ti, Nb, V, Mo, Zr, Cr, Al, Hf, Ta, Y and Si. The thickness of this layer is 0.2 - 5 µm.

The layer according to the present invention is made by a PVD technique, a PECVD technique or a hybrid of such techniques. Examples of such techniques are RF (Radio Frequency) magnetron sputtering, DC magnetron sputtering and pulsed dual magnetron sputtering (DMS). The layer is formed at a substrate temperature of 200 - 850°C.

When the type of PVD process permits, a metal oxide+metal oxide nano-composite layer is deposited using a composite oxide target material. A reactive process using metallic targets in an ambient reactive gas is an alternative process route. For the case of production of the metal oxide layers by a magnetron sputtering method, two or more single metal targets may be used where the metal oxide+metal oxide nano-composite composition is steered by switching on and off of separate targets. In a preferred method a target is a compound with a composition that reflects the desired layer composition. For the case of radio frequency (RF) sputtering, the composition is controlled by applying independently controlled power levels to the separate targets.

The aperiodic layer structure may be formed through the multiple rotation of substrates in a large scale PVD or PECVD process.

### Example 1

An aperiodic laminated multilayer consisting of alternating metal oxide+metal oxide nano-composite Al₂O₃ + ZrO₂ layers and Al₂O₃ layers, was deposited on a substrate using an RF sputtering PVD method.

The nano-composite layers were deposited with high purity oxide targets applying different process conditions in terms of temperature and zirconia to alumina ratio. The content of the two oxides in the formed nano-composite layer was controlled by applying one power level on the zirconia target and a separate power level on the alumina target. Alumina was added to the zirconia flux with the aim to form a composite material having metastable 2rO₂ phases. The target power level for this case was 80 W on each oxide target. The sputter rates were adjusted to obtain two times higher at-% of zirconium compared to aluminium. The oxygen:metal atomic ratio was 94 % of stoichiometric oxygen:metal atomic ratio.

The Al₂O₃ layers were deposited using alumina targets in an argon atmosphere.

The sputter times for the respective alternating layers were chosen to successively increase the Al₂O₃ layer thickness towards the coating surface.

The resulting layers were analyzed by XRD and TEM. The XRD analysis showed no traces of crystalline Al₂O₃ in the nano-composite layer, while the Al₂O₃ layers consisted mainly of gamma Al₂O₃.

The TEM investigation showed that the deposited coating consisted of a laminated multilayer of alternating metal oxide+metal oxide nano-composite layers, comprising grains with an average grain size of 4 nm (component A) surrounded by an amorphous phase with a linear intercept of 2 nm (component B), and gamma Al₂O₃ layers. The grains of the nano-composite layers were cubic ZrO₂ while the surrounding phase had high aluminium content. The individual layer thicknesses ranged from 4 to 20 nm and the total multilayer thickness was about 1 µm. The successive increase in the Al₂O₃ layer thickness towards the coating surface resulted in a Zr gradient such that the average Zr content was about 30 at-% higher, in absolute units, in the innermost portion than in the outermost portion of the multilayer, measured as an average Zr content over several consecutive layers in the respective portions using EDS.

The relative volume content of the two components A and B in the nano-composite layers was approximately 70 % and 30 %, respectively, as determined from ERDA analysis and EDS line scans from TEM images.

## Claims

1. A cutting tool comprising a substrate of cemented carbide, cermet, ceramics, cubic boron nitride or high speed steel on which at least on the functioning parts of the surface thereof a thin, adherent, hard and wear resistant coating is applied,
**characterised in** said coating comprises a laminated multilayer of alternating PVD or PECVD metal oxide layers, Me₁X+Me₂X+Me₁X+Me₂X..., where the metal atoms Me₁ and Me₂ are one or more of Ti, Nb, V, Mo, Zr, Cr, Al, Hf, Ta, Y and Si, preferably Hf, Ta, Zr and Al, most preferably Zr and Al, and where at least one of Me₁X and Me₂X is a metal oxide+metal oxide nano-composite layer composed of two components, component A and component B, with different composition and different structure which components consist of a single phase oxide of one metal element or a solid solution of two or more metal oxides, wherein the layers Me₁X and Me₂X are different in composition or structure or both and have individual layer thicknesses larger than 0.4 nm but smaller than 50 nm and where said laminated multilayer has a total thickness of between 0.2 and 20 µm and has a compositional gradient, with regard to the concentration of one or more of the metal atom(s), in the direction from the outer surface of the coating towards the substrate, the gradient being such that the difference in between the average concentration of the outermost portion of the multilayer and the average concentration of the innermost portion of the multilayer is at least 5 at-% in absolute units.

2. Cutting tool according to the preceding claim **characterised in that** the said individual Me₁X and Me₂X layer thicknesses are larger than 1 nm and smaller than 30 nm.

3. Cutting tool according to the preceding claim **characterised in that** the coating in addition comprises a first, inner single layer or multilayer of metal carbides, nitrides or carbonitrides with a thickness between 0.2 and 20 µm where the metal atoms are chosen from one or more of Ti, Nb, V, Mo, Zr, Cr, Al, Hf, Ta, Y or Si.

4. Cutting tool according to claim 3 **characterised in that** the one or more of the metal atom(s) of the at least one metal oxide+metal oxide nano-composite layer is a stronger carbide or nitride former than one or more of the metal atom(s) in the first, inner single layer or multilayer.

5. Cutting tool according to any of the preceding claims **characterised in that** the coating in addition comprises, on top of the laminated multilayer, at least one outer single layer or multilayer coating of metal carbides, nitrides or carbonitrides with a thickness between 0.2 and 5 µm where the metal atoms are chosen from one or more of Ti, Nb, V, Mo, Zr, Cr, Al, Hf, Ta, Y or Si.

6. Cutting tool according to any of the preceding claims **characterised in that** said component A has an average grain size of 1 - 100 nm, preferably 1 - 70 nm, most preferably 1 - 20 nm.

7. Cutting tool according to the preceding claims **characterised in that** said component B has a mean linear intercept of 0.5 - 200 nm, preferably 0.5 - 50 nm, most preferably 0.5 - 20 nm.

8. Cutting tool according to any of the preceding claims **characterised in that** the volume contents of component A and B are 40 - 95 % and 5 - 60 % respectively.

9. Cutting tool according to any of the preceding claims **characterised in that** said component A contains tetragonal or cubic zirconia and said component B consists of amorphous or crystalline alumina, of one or both of the alpha (α) and the gamma (γ) phase.

10. Cutting tool according to any of the preceding claims **characterised in that** M₁X is a metal oxide+metal oxide nano-composite layer and Me₂X is crystalline alumina layer of one or both of the alpha (α) and the gamma (γ) phase.

## Patentansprüche

1. Schneidwerkzeug mit einem Substrat aus Hartmetall, Cermet, Keramik, kubischem Bornitrid oder Schnellarbeitsstahl, auf welchem zumindest auf den arbeitenden Teilen von dessen Oberfläche eine dünne, anhaftende, harte und verschleißbeständige Beschichtung aufgebracht ist, **dadurch gekennzeichnet, dass** die Beschichtung eine laminierte Mehrfachlage alternierender PVD- oder PECVD-Metalloxidschichten, Me₁X+Me₂X+ Me₁X+Me₂X..., umfasst, wobei die Metallatome Me₁ und Me₂ aus einem oder mehreren von Ti, Nb, V, Mo, Zr, Cr, Al, Hf, Ta, Y und Si, vorzugsweise Hf, Ta, Zr und Al, besonders bevorzugt Zr und Al, bestehen und wobei zumindest M₁X oder Me₂X eine Nanoverbundschicht aus Metalloxid+Metalloxid aus zwei Komponenten, Komponente A und Komponente B, ist, die eine unterschiedliche Zusammensetzung und eine unterschiedliche Struktur aufweisen und deren Komponenten aus einem einphasigen Oxid eines Metallelementes oder einer festen Lösung aus zwei oder mehr Metalloxiden bestehen, wobei sich die Me₁X- und Me₂X- Schichten in Zusammensetzung und/oder Struktur unterscheiden und individuelle Schichtdicken größer als 0,4 nm, aber kleiner als 50 nm, aufweisen, wobei die laminierte Mehrfachlage eine Gesamtdicke zwischen 0,2 und 20 µm hat und einen hinsichtlich der Konzentration eines oder mehrerer der Metallatome und in Richtung von der äußeren Oberfläche der Beschichtung zu dem Substrat Gradienten der Zusammensetzung aufweist, wobei der Gradient derart ausgestaltet ist, dass die Differenz zwischen der mittleren Konzentration des am weitesten außenliegenden Abschnittes der Mehrfachlage und der mittleren Konzentration des am weitesten innenliegenden Abschnittes der Mehrfachlage zumindest 5 at-% in absoluten Einheiten ist.

2. Schneidwerkzeug nach dem vorangehenden Anspruch, **dadurch gekennzeichnet, dass** die einzelnen Me₁X- und Me₂X-Schichtdicken größer als 1 nm und kleiner als 30 nm sind.

3. Schneidwerkzeug nach dem vorangehenden Anspruch, **dadurch gekennzeichnet, dass** die Beschichtung zusätzlich eine erste, innere Einzel- oder Mehrfachlage aus Metallcarbiden, -nitriden oder -carbonitriden mit einer Dicke zwischen 0,2 und 20 µm aufweist, wobei die Metallatome unter einem oder mehreren der Elemente Ti, Nb, V, Mo, Zr, Cr, Al, Hf, Ta, Y oder Si ausgewählt sind.

4. Schneidwerkzeug nach Anspruch 3, **dadurch gekennzeichnet, dass** das eine oder die mehreren der Metallatom(e) der zumindest einen Nanoverbundschicht aus Metalloxid + Metalloxid ein stärkerer Carbid- oder Nitridbildner ist als das eine oder die mehrere der Metallatome in der ersten inneren Einzel- oder Mehrfachlage.

5. Schneidwerkzeug nach einem der vorangehenden Ansprüche, **dadurch gekennzeichnet, dass** die Beschichtung auf der laminierten Mehrfachlage zusätzlich zumindest eine äußere ein- oder mehrlagige Beschichtung aus Metallcarbiden, -nitriden oder -carbonitriden mit einer Dicke zwischen 0,2 und 5 µm aufweist, wobei die Metallatome unter einem oder mehreren von Ti, Nb, V, Mo, Zr, Cr, Al, Hf, Ta, Y oder Si ausgewählt sind.

6. Schneidwerkzeug nach einem der vorangehenden Ansprüche, **dadurch gekennzeichnet, dass** die Komponente A eine mittlere Korngröße von 1-100 nm, vorzugsweise 1-70 nm und besonders bevorzugt 1-20 nm aufweist.

7. Schneidwerkzeug nach den vorangehenden Ansprüchen, **dadurch gekennzeichnet dass** die Komponente B einen mittleren Linienschnitt bzw. Korndurchtrittslänge (linear intercept) von 0,5-200 nm, vorzugsweise 0,5-50 nm und besonders bevorzugt 0,5-20 nm hat.

8. Schneidwerkzeug nach einem der vorangehenden Ansprüche, **dadurch gekennzeichnet, dass** die Volumengehalte von Komponente A und B 40-95 % bzw. 5-60 % betragen.

9. Schneidwerkzeug nach einem der vorangehenden Ansprüche, **dadurch gekennzeichnet, dass** die Komponente A tetragonales oder kubisches Zirkonoxid umfasst und die Komponente B aus amorphem oder kristallinem Aluminiumoxid der Alpha- (α) und/oder der Gamma- (γ)-Phase besteht.

10. Schneidwerkzeug nach einem der vorangehenden Ansprüche, **dadurch gekennzeichnet, dass** Me₁X eine Nanoverbundschicht aus Metalloxid + Metalloxid und Me₂X eine kristalline Aluminiumoxidschicht der Alpha- (α) und/oder der Gamma- (γ)-Phase ist.

## Revendications

1. Outil de coupe comprenant un substrat de carbure cémenté, cermet, céramique, nitrure de bore cubique ou acier à coupe rapide, sur au moins une des parties fonctionnelles de la surface duquel un revêtement mince, adhérent, dur et résistant à l'usure est appliqué, **caractérisé en ce que** ledit revêtement comprend une multicouche stratifiée de couches alternées d'oxyde de métal PVD ou PECVD, Me₁X+Me₂X+Me₁X+Me₂X..., où les atomes de métal Me₁ et Me₂ sont l'un ou plusieurs de Ti, Nb, V, Mo, Zr, Cr, Al, Hf, Ta, Y et Si, de préférence Hf, Ta, Zr et Al, de manière préférée entre toutes Zr et Al, et où au moins l'un de Me₁X et Me₂X est une couche nanocomposite d'oxyde de métal+oxyde de métal composée de deux composants, le composant A et le composant B, ayant différentes compositions et différentes structures, lesdits composants étant constitués d'un oxyde monophase d'un élément métallique ou une solution solide de deux oxydes de métal ou plus, les couches Me₁X et Me₂X étant différentes en termes de composition ou de structure ou les deux et ont des épaisseurs de couches individuelles supérieures à 0,4 nm mais inférieures à 50 nm et où ladite multicouche stratifiée a une épaisseur totale comprise entre 0,2 et 20 µm et a un gradient de composition, en ce qui concerne la concentration d'un ou plusieurs du/des atome(s) de métal, dans la direction de la surface externe du revêtement vers le substrat, le gradient étant tel que la différence entre la concentration moyenne de la partie la plus externe de la multicouche et la concentration moyenne de la partie la plus interne de la multicouche est d'au moins 5 % atomique en unités absolues.

2. Outil de coupe selon la revendication précédente **caractérisé en ce que** lesdites épaisseurs de couches individuelles Me₁X et Me₂X sont supérieures à 1 nm et inférieures à 30 nm.

3. Outil de coupe selon la revendication précédente **caractérisé en ce que** le revêtement comprend en outre une première couche unique ou multicouche interne de carbures, nitrures ou carbonitrures de métal ayant une épaisseur comprise entre 0,2 et 20 µm où les atomes de métal sont choisis parmi l'un ou plusieurs de Ti, Nb, V, Mo, Zr, Cr, Al, Hf, Ta, Y ou Si.

4. Outil de coupe selon la revendication 3 **caractérisé en ce que** l'un ou plusieurs du/des atome(s) de métal de l'au moins une couche nanocomposite d'oxyde de métal+oxyde de métal est un formeur de carbure ou nitrure plus fort qu'un ou plusieurs du/des atome(s) de métal dans la première couche unique ou multicouche interne.

5. Outil de coupe selon l'une quelconque des revendications précédentes **caractérisé en ce que** le revêtement comprend en outre, au-dessus de la multicouche stratifiée, au moins un revêtement de couche unique ou multicouche externe de carbures, nitrures ou carbonitrures de métal ayant une épaisseur comprise entre 0,2 et 5 µm où les atomes de métal sont choisis parmi l'un ou plusieurs de Ti, Nb, V, Mo, Zr, Cr, Al, Hf, Ta, Y ou Si.

6. Outil de coupe selon l'une quelconque des revendications précédentes **caractérisé en ce que** ledit composant A a une grosseur de grain moyenne de 1 à 100 nm, de préférence de 1 à 70 nm, de manière préférée entre toutes de 1 à 20 nm.

7. Outil de coupe selon les revendications précédentes **caractérisé en ce que** ledit composant B a une intersection linéaire moyenne de 0,5 à 200 nm, de préférence de 0,5 à 50 nm, de manière préférée entre toutes de 0,5 à 20 nm.

8. Outil de coupe selon l'une quelconque des revendications précédentes **caractérisé en ce que** les teneurs en volume des composants A et B sont de 40 à 95 % et de 5 à 60 % respectivement.

9. Outil de coupe selon l'une quelconque des revendications précédentes **caractérisé en ce que** ledit composant A contient de l'oxyde de zirconium tétragonal ou cubique et ledit composant B est constitué d'alumine amorphe ou cristalline, de l'une ou les deux des phases alpha (α) et gamma (γ).

10. Outil de coupe selon l'une quelconque des revendications précédentes **caractérisé en ce que** Me₁X est une couche de nanocomposite d'oxyde de métal+oxyde de métal et Me₂X est une couche d'alumine cristalline de l'une ou les deux des phases alpha (α) et gamma (γ).
